# EUROPEAN PATENT SPECIFICATION

(11) **EP 0 836 278 B1**
(45) Date of publication and mention of the grant of the patent: **24.07.2002**
(21) Application number: 97117419.8
(22) Date of filing: 08.10.1997
(51) Int. Cl.: H03H 9/64

(54) **Elastic surface wave filter device**
Filteranordnung mit elastischen Oberflächenwellen
Dispositif de filtrage à ondes élastiques de surface

(30) Priority: 09.10.1996 JP 26839796
(43) Date of publication of application: 15.04.1998
(73) Proprietor: MURATA MANUFACTURING CO., LTD., Nagaokakyo-shi,Kyoto (JP)
(72) Inventor: Tada, Yutaka, Nagaokakyo-shi, Kyoto-fu (JP)
(74) Representative: Laufhütte, Dieter, Dr.-Ing.

(56) References cited:
- FR-A- 2 682 833
- US-A- 5 365 138

## Description

The present invention relates to an elastic surface wave filter device.

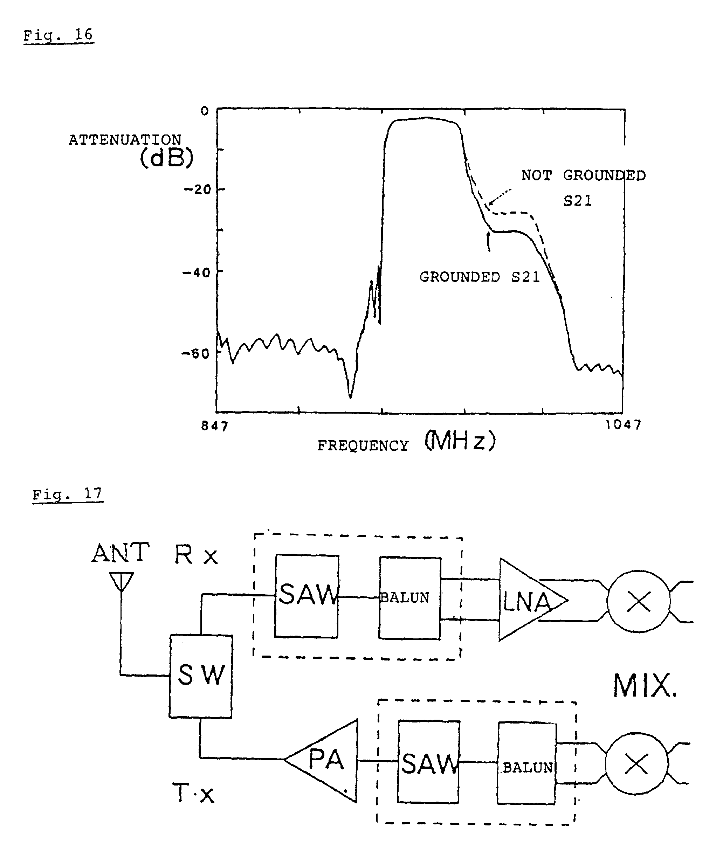

Recently, with a reduction in size and cost of mobile body terminals, it has also been considered to reduce the number of parts and combine several parts into a composite form in the circuit configuration of a set. Recent elastic surface wave filter devices have succeeded in reducing loss and have begun to be employed in antenna top units as well. Fig. 17 shows one example of elastic surface wave filter devices used in mobile body terminals, taking the reception side (RX) as an instance. Generally, an RF signal is input from an antenna (ANT) through a switch (SW) to an elastic surface wave filter device (SAW) with unbalanced terminals and characteristic impedance of 50 Ω. On the other hand, an amplifier (LNA) is of operational amplifier type and has balanced terminals in many cases. This means that the amplifier requires characteristic impedance on the order of about 150 - 200 Ω to receive an input if unbalanced terminals are employed. However, most of elastic surface wave filter devices (SAW) usually have input/output impedance of 50 Ω in themselves and unbalanced input/output terminals. For this reason, although elastic surface wave filter devices can be directly connected to the antenna (ANT) side, a matching circuit for impedance conversion and an unbalanced - balanced transformer have been required for connection to the amplifier (LNA) side. A balun circuit (hereinafter referred to simply as a balun) has been hitherto used for that end, but the use of a balun has been the cause for increasing the number of parts and cost. There has been thus a demand for eliminating the use of a matching circuit and an unbalanced-balanced transformer.

Of late, a variety of studies have been made to meet the above demand. Japanese Unexamined Patent Publication No. 7-288442, for example, realizes a filter of balanced input - balanced output type by connecting elastic surface wave resonators in a symmetrical grid pattern.

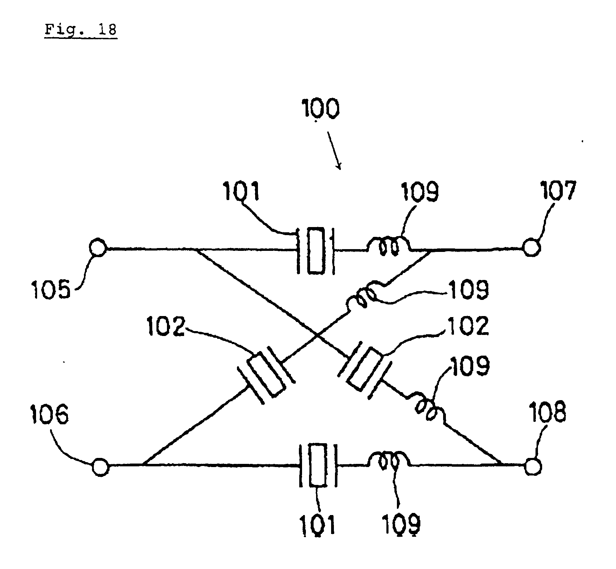

Fig. 18 shows the construction of an elastic surface wave filter device disclosed in the above-cited Japanese Unexamined Patent Publication No. 7-288442. As shown in Fig. 18, an elastic surface wave filter device 100 comprises two serial arm resonators 101, 101 and two parallel arm resonators 102, 102. Input terminals of one serial arm resonator 101 and one parallel arm resonator 102 are connected to an input terminal 105, and input terminals of the other serial arm resonator 101 and the other parallel arm resonator 102 are connected to an input terminal 106.

Output terminals of one serial arm resonator 101 and the other parallel arm resonator 102 are connected to an output terminal 107, and output terminals of the other serial arm resonator 101 and one parallel arm resonator 102 are connected to an output terminal 108.

Also, an inductor 109 is connected in series to each of all the resonators 101 - 102.

The elastic surface wave filter device of balanced input - balanced output type is realized with the above construction. But the disclosed elastic surface wave filter device cannot be applied, as it is, to a system of unbalanced input-balanced output. As described in "A New Balanced - Unbalanced Type RF-Band SAW Filter", 1996 IEEE MTT-S Digest WE1A-5 (p 417-420) and Japanese Unexamined Patent Publication No. 8-65098, therefore, a filter of unbalanced input - balanced output type is realized by connecting one of input IDTs to a ground terminal and output IDTs to the input terminals 105, 106 of the elastic surface wave filter device shown in Fig. 18.

Although a filter of unbalanced input - balanced output type can be realized according to the method of the above-cited Japanese Unexamined Patent Publication No. 8-65098, the elastic surface wave filter device is only constructed to still have in itself conventional characteristic impedance, i.e., equal input and output impedance values such as 50 Ω - 50 Ω, and a matching device for impedance matching is required for connection to the amplifier side having input impedance on the order of about 150 - 200 Ω. Further, because the balanced output can be only realized in floating type, there arises a problem that a degree of balance outside the band is not complete and direct incoming waves cannot be sufficiently cancelled out.

An elastic surface wave filter device of floating type accompanies a problem that the presence of a ground terminal in the filter input side affects an output terminal and a filter characteristic is varied from a desired value.

Additionally, to achieve connection to the amplifier side without a matching circuit, the impedance on the output side should not be equal to the impedance on the input side, but is required to be on the order of about 150 - 200 Ω, i.e., about three or four times as much as the input impedance. A problem of increasing mismatching loss would result it attempting to realize such an unbalanced impedance construction only by improving design of an elastic surface wave filter itself.

US-A-5365138 discloses a double mode surface wave resonator the coupling of which includes a primary mode and a higher mode. The single filters disclosed in this document may be divided into halves. FR-A-2682833 discloses a two track filter.

The present invention is intended to overcome the above mentioned problems in matching of impedance and incompleteness of balance together and its object is to provide an elastic surface wave filter device which can realize balanced operation with a neutral terminal kept at a ground potential, and which is adaptable for any system of unbalanced input-balanced output or balanced input-unbalanced output even with an input and an output being different in characteristic and impedance from each other.

This object is achieved with an elastic surface wave filter apparatus having the features of claim 1.

By cascading the elastic surface wave filters in multiple stages, the filter device can have such a construction that IDTs connected between the stages have no ground terminals thus developing a buffer effect.

Further, since two elastic surface wave filters are connected in parallel on the input side and two elastic surface wave filters are connected in series on the output side with one of the two filters providing reversed phase, output impedance is about four times as much as input impedance and the balanced output is obtained.

The subclaims are directed to preferable embodiments.

An elastic surface wave filter apparatus in accordance with claim 2 makes it possible to realize the balanced operation with a neutral potential given by the ground potential.

By making the orientation of the input IDT or the output IDT reversed on the side where the IDT is connected to lie between the stages in line with one of the claims 3, 4, 8 or 9 or by making the spacing between the input and output IDTs of the relevant filter different in line with claim 5 or claim 10, the phase can be reversed.

With an elastic surface acoustic wave filter apparatus having the features of claim 6 or claim 11, directly incoming waves can be suppressed with increased attenuation.

In an elastic surface acoustic wave filter apparatus having the features of one of the claims 7 or 12 it is possible to prevent a change in parasitic capacitance that occurs when phase reversed by changing the orientation of the input IDT or the output IDT.

### BRIEF DESCRIPTION OF THE DRAWINGS

Fig. 1 is a view showing the construction of an elastic surface wave filter device according to a first embodiment of the present invention.

Fig. 2 is a transmission characteristic graph showing the operation of the filter device according to the first embodiment.

Fig. 3 is a view showing the construction of an elastic surface wave filter device according to a second embodiment of the present invention.

Fig. 4 is a transmission characteristic graph showing the operation of the filter device according to the second embodiment, the graph plotting two transmission characteristics measured between an unbalanced input terminal and each of balanced output terminals.

Fig. 5 is a transmission characteristic graph showing the operation of the filter device according to the second embodiment, the graph plotting a transmission characteristic measured when a signal is obtained from an unbalanced output terminal through a balun.

Fig. 6 is a view showing the construction of an elastic surface wave filter device according to a third embodiment of the present invention.

Fig. 7 is a transmission characteristic graph showing the operation of the filter device according to the third embodiment, the graph plotting two transmission characteristics measured between an unbalanced input terminal and each of balanced output terminals.

Fig. 8 is a transmission characteristic graph showing the operation of the filter device according to the third embodiment, the graph plotting a transmission characteristic measured when a signal is obtained from an unbalanced output terminal through a balun.

Fig. 9 is a view showing the construction of an elastic surface wave filter device according to a fourth embodiment of the present invention.

Fig. 10 is a partial detailed view showing the relationship in spacing from an input IDT to an output IDT between an elastic surface wave filter 3c and an elastic surface wave filter 34.

Fig. 11 is a transmission characteristic graph showing the operation of the filter device according to the third embodiment, the graph plotting a transmission characteristic measured between an unbalanced input terminal (port 1) and a balanced output terminal (port 2).

Fig. 12 is a transmission characteristic graph showing the operation of the filter device according to the third embodiment, the graph plotting a transmission characteristic measured between the unbalanced input terminal (port 1) and a balanced output terminal (port 3).

Fig. 13 is a transmission characteristic graph showing the operation of the filter device according to the fourth embodiment, the graph plotting a transmission characteristic measured between an unbalanced input terminal (port 1) and a balanced output terminal (port 3).

Fig. 14 is a view showing the construction of an elastic surface wave filter device according to a fifth embodiment of the present invention.

Fig. 15 is a view showing the construction of an elastic surface wave filter device according to a sixth embodiment of the present invention.

Fig. 16 is a transmission characteristic graph showing the operation of the filter device according to the sixth embodiment, the graph plotting a transmission characteristic measured when a signal is obtained from an unbalanced output terminal through a balun.

Fig. 17 is a block diagram showing an example of elastic surface wave filters used in a mobile body communication terminal.

Fig. 18 is a schematic view showing the construction of a conventional elastic surface wave filter device of balanced input - unbalanced output type.

### DESCRIPTION OF THE PREFERRED EMBODIMENTS

The present invention will be described hereunder in detail with reference to the drawings.

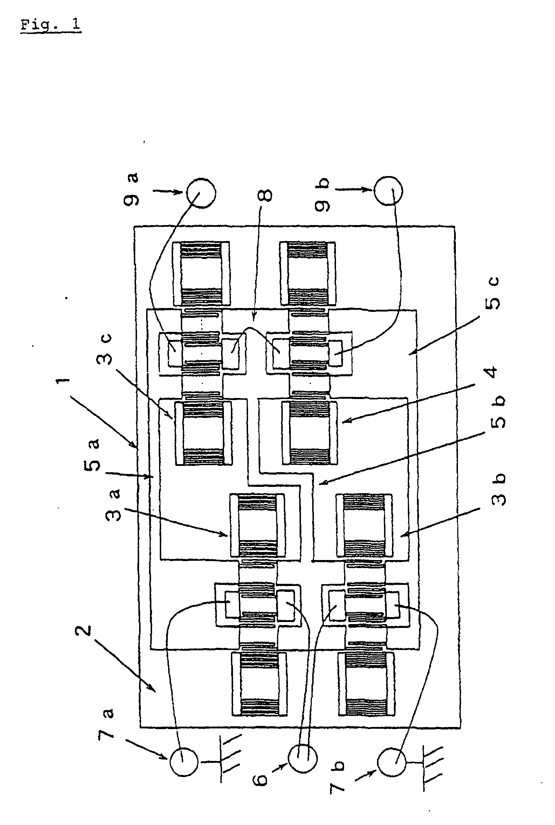

Fig. 1 is a view showing the construction of an elastic surface wave filter device according to a first embodiment of the present invention. In Fig. 1, an elastic surface wave filter device 1 comprises four elastic surface wave filters 3a, 3b, 3c, 4 formed on a piezoelectric substrate 2, the three elastic surface wave filters 3a, 3b, 3c having the same amplitude and phase characteristics within the band, the remaining elastic surface wave filter 4 having a phase characteristic different about 180 degrees from the above three filters.

The elastic surface wave filters 3a, 3c are electrically cascaded through connecting electrodes 5a, 5b, and the elastic surface wave filters 3b, 4 are also likewise electrically cascaded through connecting electrodes 5b, 5c. Input terminals of the elastic surface wave filters 3a, 3b are electrically connected in parallel and then led out to an unbalanced input terminal 6 and ground terminals 7a, 7b. On the other hand, the elastic surface wave filters 3c, 4 are electrically connected in series through a serial connecting electrode 8 and then led out to balanced output terminals 9a, 9b.

Further, the elastic surface wave filter 3a and the elastic surface wave filter 3c have input IDTs and output IDTs being configured in the same orientation.

The elastic surface wave filter 4 has an input IDT configured in the same orientation as an output IDT of the elastic surface wave filter 3b, and an output IDT configured in the opposite orientation to an input IDT of the elastic surface wave filter 3b.

It is to be noted that the IDTs and reflectors of the elastic surface wave filters are simplified for the sake of convenience because the number of pairs of electrode fingers is too many to illustrate them individually.

In the above structure, the elastic surface wave filters 3a, 3b, 3c have the same amplitude and phase in input/output transmission characteristic within the band, whereas the elastic surface wave filter 4 has an input/output phase characteristic different about 180 degrees from the above three filters.

The operation of the elastic surface wave filter device thus constructed will be described below. An RF signal from the input side is applied through the unbalanced input terminal 6 and converted into surface waves in the elastic surface wave filters 3a, 3b. After that, the surface waves are converted into an electrical signal again which is led out to the electrodes 5a, 5b, 5c. The input side of the elastic surface wave filter device 1 is connected to the unbalanced input terminal 6 and the ground terminals 7a, 7b, and therefore includes a ground potential. Since an input signal voltage applied to the unbalanced input terminal 6 with respect to the ground terminals 7a, 7b on the input side is converted into a signal voltage between the balanced terminals 9a, 9b through the elastic surface wave filter device 1, signals having completely the same amplitude and the opposite phase as and to the input signal could not be obtained between the balanced output terminals if an effect of the ground potential on the input side reaches the output side. In the elastic surface wave filter device 1, however, since no ground terminals are provided in the electrodes 5a, 5b, 5c for connection to the elastic surface wave filters in the downstream stage, the input signal is transmitted to the elastic surface wave filter 3c and the elastic surface wave filter 4 without being affected by the ground terminals 7a, 7b. Additionally, since the output IDT of the elastic surface wave filter 4 has the orientation made different to have a phase reversing function, signals being opposite in phase to each other are obtained at the balanced output terminals 9a, 9b.

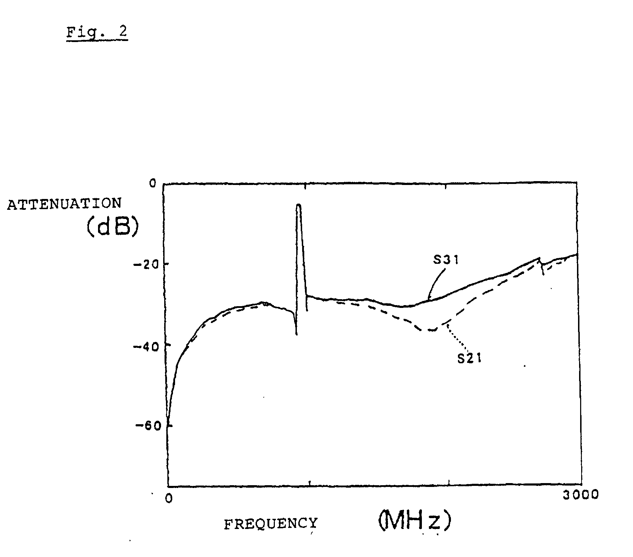

Fig. 2 shows transmission characteristics of the elastic surface wave filter device 1 according to the first embodiment measured on condition of a 50 Ω system, taking the filter device 1 as a 3-port device. In Fig. 2, a solid line represents a transmission characteristic (S31) measured between the unbalanced input terminal 6 (port 1) and the balanced output terminal 9b (port 3) in the first embodiment of Fig. 1, and a broken line represents a transmission characteristic (S21) measured between the unbalanced input terminal 6 (port 1) and the balanced output terminal 9a (port 2). Incidentally, the terminal not taking part in the measurement is terminated with 50 Ω.

Input/output impedance of the elastic surface wave filter device 1 will be explained below. The elastic surface wave filters 3a, 3b, 3c and the elastic surface wave filter 4 have the same interdigital interval between electrode fingers and the number of pairs of IDTs except that the output IDT of the filter 4 is configured in the opposite orientation; hence all the filters have the same characteristic impedance Z0. Since the elastic surface wave filters 3a, 3b are electrically connected in parallel, the impedance looking from the unbalanced input terminal 6 is Z0/2. On the other hand, since the elastic surface wave filters 3c, 4 are electrically connected in series, the impedance looking from the balanced input terminals 9a, 9b is 2Z0. Accordingly, if the individual elastic surface wave filters are designed to provide characteristic impedance of 100 Ω, for example, an elastic surface wave filter device having input impedance of 50 Ω and output impedance of 200 Ω can be realized.

While in the first embodiment the elastic surface wave filter 4 has the input IDT configured in the same orientation as the output IDT of the elastic surface wave filter 3b, and the output IDT configured in the opposite orientation to the input IDT of the elastic surface wave filter 3b, the present invention is not limited to the first embodiment. On the contrary, the elastic surface wave filter 4 may have the input IDT configured in the opposite orientation to the output IDT of the elastic surface wave filter 3b, and the output IDT configured in the same orientation as the input IDT of the elastic surface wave filter 3b.

A second embodiment will be described below.

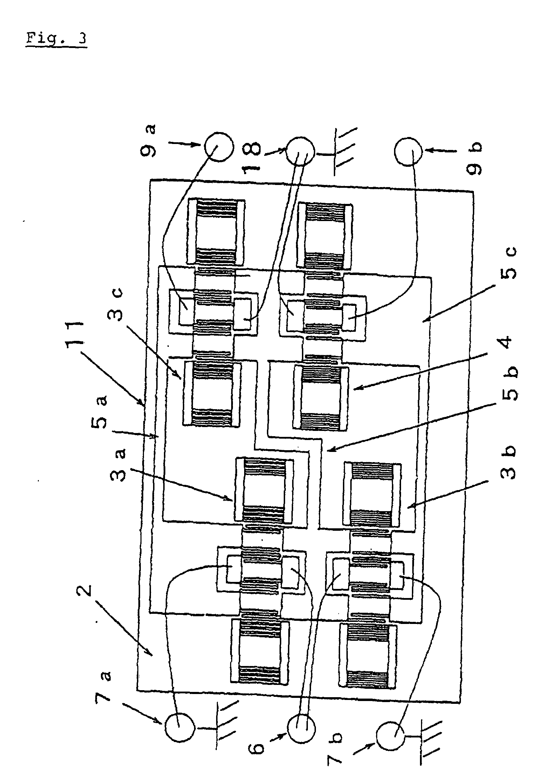

Fig. 3 is a view showing the construction of an elastic surface wave filter device 11 according to a second embodiment of the present invention. Because the basic construction of the elastic surface wave filter device 11 is similar to that of the first embodiment, the same parts as those in the first embodiment shown in Fig. 1 are denoted by the same reference numerals and are not described here in detail.

As shown in Fig. 3, the elastic surface wave filter device 11 comprises four elastic surface wave filters formed on the piezoelectric substrate 2.

This second embodiment differs from the first embodiment in that while the output IDTs of the elastic surface wave filters 3c, 4 are electrically connected in series through the serial connecting electrode 8 in the first embodiment, the output IDTs of the elastic surface wave filters 3c, 4 are both led to a ground terminal 18.

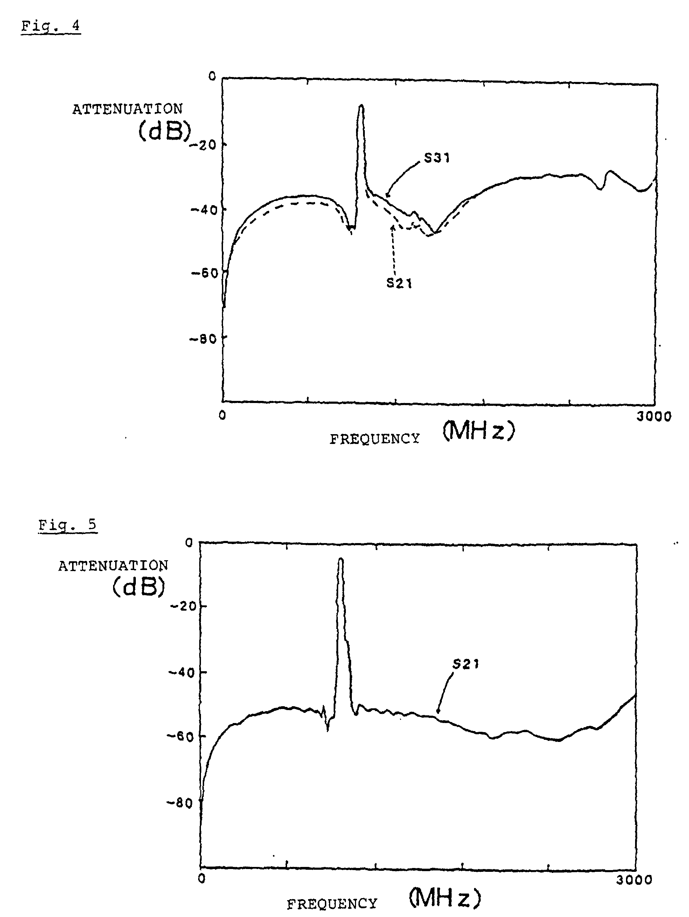

Fig. 4 shows, similarly to Fig. 2, transmission characteristics (S21 and S31) of the elastic surface wave filter device 11 according to the second embodiment. Specifically, in Fig. 4, a solid line represents a transmission characteristic (S31) measured between the unbalanced input terminal 6 (port 1) and the balanced output terminal 9b (port 3), and a broken line represents a transmission characteristic (S21) measured between the unbalanced input terminal 6 (port 1) and the balanced output terminal 9a (port 2). Incidentally, the terminal not taking part in the measurement is terminated with 50 Ω. As will be seen from Fig. 4, attenuation is improved about 10 dB for directly incoming waves in the vicinity of 1 GHz in comparison with the transmission characteristic of the first embodiment shown in Fig. 2.

Fig. 5 shows a transmission characteristic (S21) resulted from this second embodiment after the balanced output operation. The result of Fig. 5 represents the transmission characteristic measured when a transformer (balun) for transforming a balanced output on the order of 200 Ω into an unbalanced output on the order of 50 Ω is connected to the balanced output terminals 9a, 9b of the elastic surface wave filter device 11 and a signal is obtained from the balun.

With the construction of the second embodiment, since the balanced operation with a neutral potential given by the ground potential is realized, it is possible to realize an elastic surface wave filter device which can suppress directly incoming waves more positively than with the floating operation and is superior in suppressing unnecessary waves.

A third embodiment will be described below.

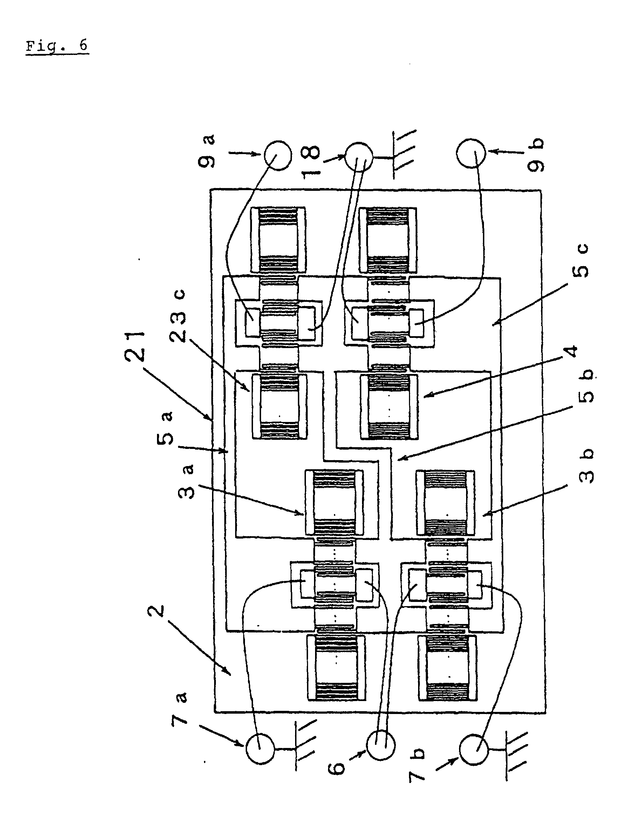

Fig. 6 is a view showing the construction of an elastic surface wave filter device 21 according to a third embodiment of the present invention. Because the basic construction of the elastic surface wave filter device 21 is similar to that of the second embodiment, the same parts as those in the second embodiment are denoted by the same reference numerals and are not described here in detail.

This third embodiment differs from the second embodiment in that while the elastic surface wave filters 3a, 3b have the input IDTs and the output IDTs both configured in the same orientation in the second embodiment, an input IDT and an output IDT of an elastic surface wave filter 23c are configured in the opposite orientation to the input IDT and the output IDT of the elastic surface wave filter 3a.

Such a construction is employed in order that a common electrode to electrode fingers on the side connected to the balanced output terminal 9a of the elastic surface wave filter 23c and a common electrode to electrode fingers on the side connected to the balanced output terminal 9b of the elastic surface wave filter 4 each cover the same number of electrode fingers.

Specifically, as shown in Fig. 6, for the output IDT of the elastic surface wave filter 23c to be connected to the balanced output terminal 9a, one common electrode having electrode fingers which locate at outermost positions in that output IDT is connected to the ground terminal 18, and the other common electrode is connected to the balanced output terminal 9a. For the output IDT of the elastic surface wave filter 4 to be connected to the balanced output terminal 9b, one common electrode having electrode fingers which locate at outermost positions in that output IDT is connected to the ground terminal 18, and the other common electrode is connected to the balanced output terminal 9b.

Contrary to Fig. 6, the construction may be modified such that for the output IDT of the elastic surface wave filter 23c to be connected to the balanced output terminal 9a, one common electrode having electrode fingers which locate at outermost positions in that output IDT is directly connected to the balanced output terminal 9a, and for the output IDT of the elastic surface wave filter 4 to be connected to the balanced output terminal 9b, one common electrode having electrode fingers which locate at outermost positions in that output IDT is directly connected to the balanced output terminal 9b, the other common electrodes of the respective output IDTs being connected to the ground terminal 18. In any of those constructions, it is essential that the number of electrode fingers of the common electrode on the side of the elastic surface wave filter 23c connected to the balanced output terminal 9a and the number of electrode fingers of the common electrode on the side of the elastic surface wave filter 4 connected to the balanced output terminal 9b are set equal to each other; i.e., those common electrodes are set to have the same number of electrode fingers.

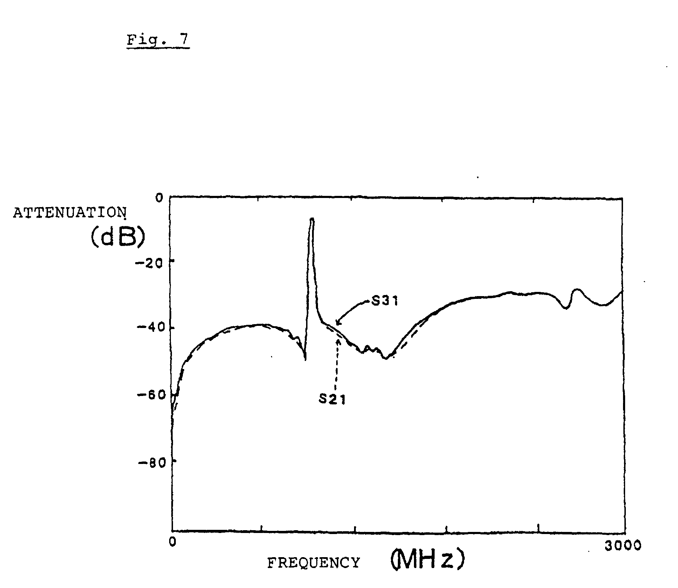

An advantage of this third embodiment will be explained below in detail. Fig. 7 shows transmission characteristics of the elastic surface wave filter device 21 according to the third embodiment measured on condition of a 50 Ω system, taking the filter device 21 as a 3-port device. In Fig. 7, a solid line represents a transmission characteristic (S31) measured between the unbalanced input terminal 6 (port 1) and the balanced output terminal 9b (port 3), and a broken line represents a transmission characteristic (S21) measured between the unbalanced input terminal 6 (port 1) and the balanced output terminal 9a (port 2). Incidentally, the terminal not taking part in the measurement is terminated with 50 Ω.

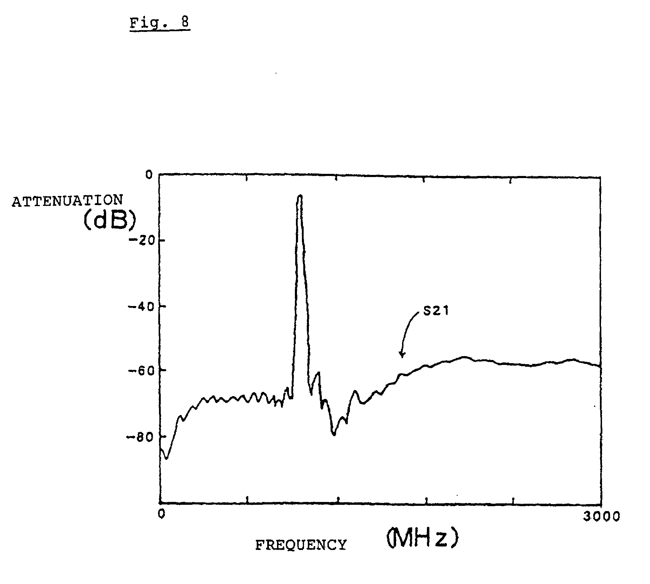

To achieve a high S/N ratio in the balanced output operation, it is desired that the filter device has transmission characteristics of the same amplitude and opposite phase within the band in which necessary signals pass, and transmission characteristics of the same amplitude and phase outside the pass band where there exist unnecessary signals. It is also apparent that, outside the pass band, a transmission characteristic of the same phase can be obtained because the directly incoming wave components are dominant, but a suppression degree is deteriorated if there is a slight amplitude difference. As will be seen from the result of Fig. 7, according to this third embodiment, signals obtained at the balanced output terminals have the same amplitude outside the pass band. Fig. 8 shows a transmission characteristic (S21) resulted from this third embodiment after the balanced output operation . The result of Fig. 8 represents the transmission characteristic measured when a transformer (balun) for transforming a balanced output on the order of 200 Ω into an unbalanced output on the order of 50 Ω is connected to the balanced output terminals 9a, 9b of the elastic surface wave filter device 21 and a signal is obtained from the balun. Comparing Fig. 5 resulted from the second embodiment and Fig. 8 resulted from this third embodiment, it is apparent that directly incoming waves can be suppressed more remarkably with this third embodiment.

A fourth embodiment will be described below.

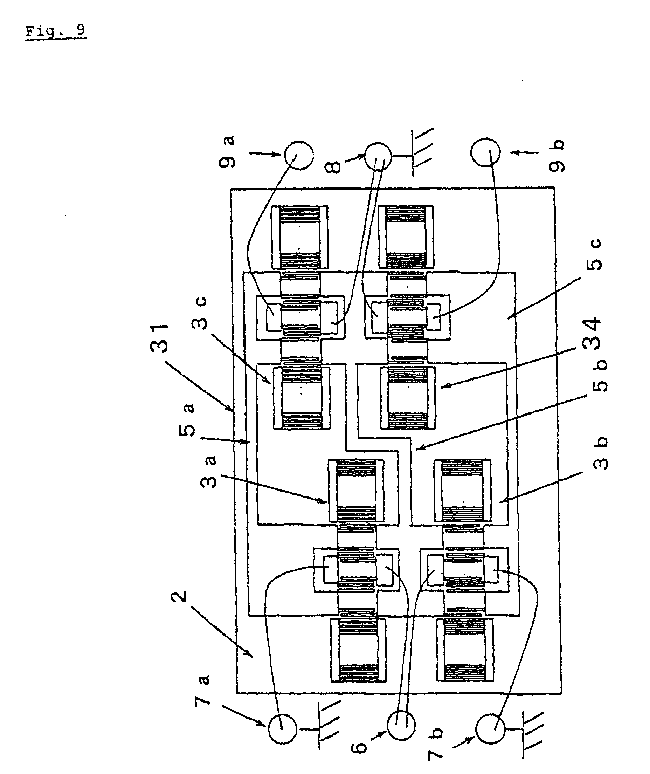

Fig. 9 is a view showing the construction of an elastic surface wave filter device 31 according to a fourth embodiment of the present invention. Because the basic construction of the elastic surface wave filter device 31 is similar to that of the second embodiment, the same parts as those in the second embodiment are denoted by the same reference numerals and are not described here in detail.

This fourth embodiment differs from the second embodiment in that while the output IDT of the elastic surface wave filter 4 is made different in orientation in the second embodiment, the fourth embodiment uses an elastic surface wave filter 34 modified such that the spacing between an electrode finger of an input IDT and an electrode finger of an output IDT is made different about 0.5 wavelength from that of the other elastic surface wave filters 3a, 3b, 3c, while the input or output IDT remains the same in orientation.

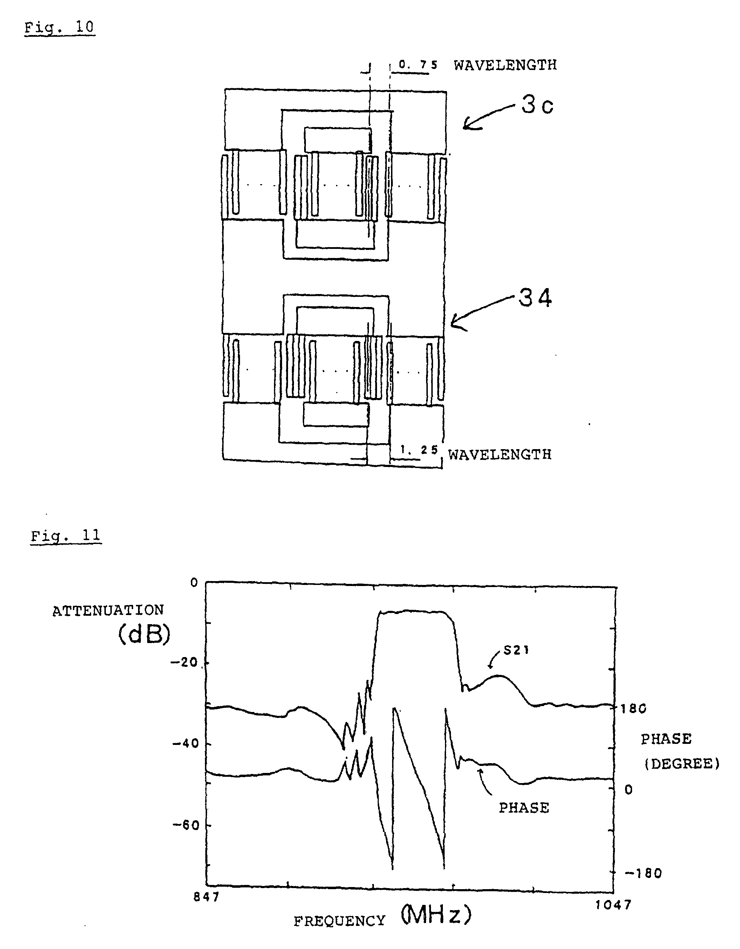

Fig. 10 is a partial enlarged view of the vicinity of the elastic surface wave filter 3c and the elastic surface wave filter 34. As shown in Fig. 10, the spacing between the adjacent electrode fingers of the input and output IDTs of the elastic surface wave filter 3c is set to 0.75 wavelength. Also, though not shown in Fig. 10, the spacing between the adjacent electrode fingers of the input and output IDTs of the elastic surface wave filters 3a, 3b, 3c is likewise set to 0.75 wavelength. On the other hand, the spacing between the adjacent electrode fingers of the input and output IDTs of the elastic surface wave filter 34 is set to 1.25 wavelength. Thus, the spacing between the adjacent electrode fingers of the input and output IDTs of the elastic surface wave filter 34 is made different about 0.5 wavelength from that of the other elastic surface wave filters 3a, 3b, 3c.

By making the spacing between the adjacent electrode fingers of the input and output IDTs of the elastic surface wave filter 34 different about 0.5 wavelength from that of the other elastic surface wave filters 3a, 3b, 3c like this embodiment, an input/output phase characteristic of the elastic surface wave filter 34 can also be made different about 180 degrees from that of the other elastic surface wave filters 3a, 3b, 3c as with the structure of the first and second embodiments where the orientation of the output IDT is made different.

Note that a difference in the spacing between the adjacent electrode fingers of the input and output IDTs is not limited to 0.5 wavelength, and the similar advantage can be provided if the difference is a multiple of any integer and 0.5 wavelength.

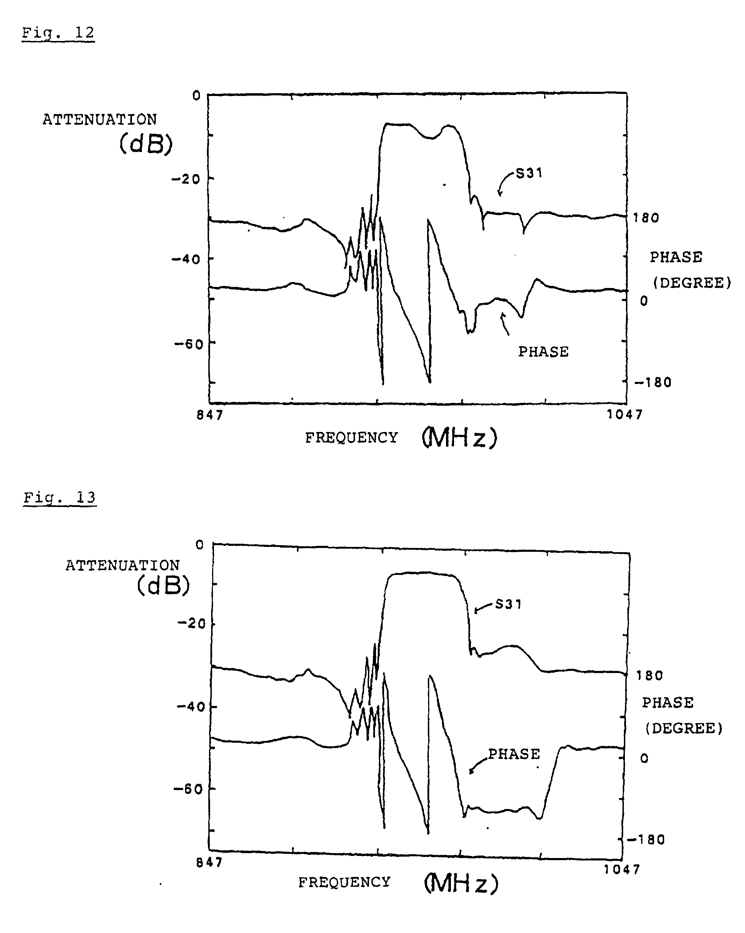

The advantage of the fourth embodiment will be explained in more detail. Figs. 11 and 12 show results of respectively measuring a transmission characteristic (S21) between the port 1 and the port 2 and a transmission characteristic (S31) between the port 1 and the port 3 in the elastic surface wave filter device 21 according to the third embodiment, particularly in the vicinity of the pass band, in the same manner as explained above in connection with the second and third embodiments, taking the filter device 21 as a 3-port device. As will be seen from these results, in the transmission characteristic (S31) shown in Fig. 12, a ripple occurs within the pass band owing to an effect caused by the elastic surface wave filter subjected to reversing of phase, and therefore the amplitude of S31 is not equal to that of S21. The reason is probably that since the orientation of one or two IDTs is reversed in the constructions of the first to third embodiments, the amplitude and phase are disturbed upon the electrode fingers inherently kept at the ground potential changing to the electrode fingers on the signal side.

To solve the above problem, the input/output phase characteristic is reversed in this fourth embodiment by changing not the orientation of the IDT, but the distance of a signal propagation path so that the amplitude and phase are not disturbed. Fig. 13 shows a transmission characteristic S31 resulted from this fourth embodiment. As will be seen from Fig. 13, the ripple within the pass band is eliminated. Incidentally, a transmission characteristic S21 resulted from this fourth embodiment is the same as shown in Fig. 11.

A fifth embodiment will be described below.

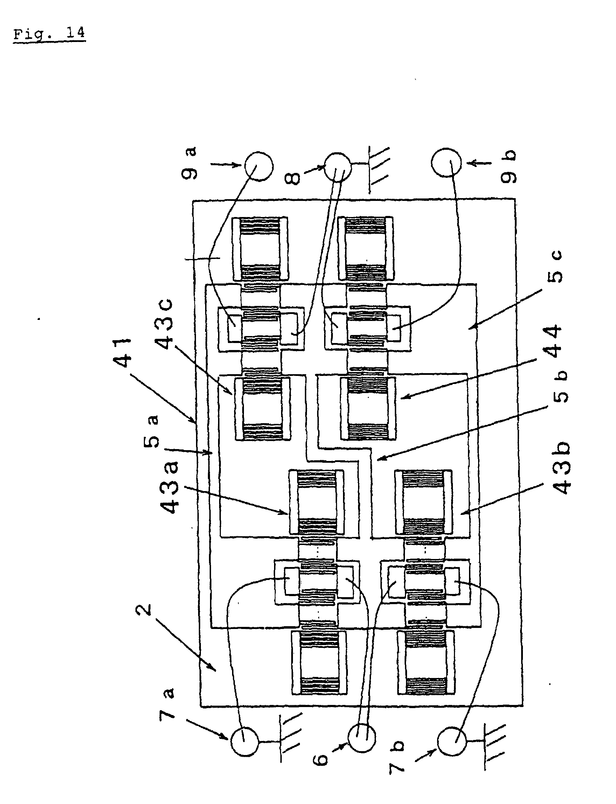

Fig. 14 is a view showing the construction of an elastic surface wave filter device 41 according to a fifth embodiment of the present invention. Because the basic construction of the elastic surface wave filter device 41 is similar to that of the second embodiment, the same parts as those in the second embodiment are denoted by the same reference numerals and are not described here in detail.

This fifth embodiment differs from the second embodiment in that input IDTs of elastic surface wave filters 43a, 43b and output IDTs of elastic surface wave filters 43c, 44 all have electrode fingers in even number. Similarly to the second embodiment, an output IDT of the elastic surface wave filter 44 is reversed in orientation to provide a phase reversing function with respect to the other elastic surface wave filters 43a, 43b, 43c.

In the elastic surface wave filter device 41 of Fig. 14, since all the IDTs of the elastic surface wave filters 43a, 43b, 43c and 44 on the side led out to the external terminals have electrode fingers in even number, there occurs no change in parasitic capacitance even with the orientation of the IDT reversed. As with the fourth embodiment, therefore, it is possible to prevent the amplitude and phase from being disturbed upon the electrode fingers inherently kept at the ground potential changing to the electrode fingers on the signal side as a result of reversing the orientation of the IDT.

A sixth embodiment will be described below.

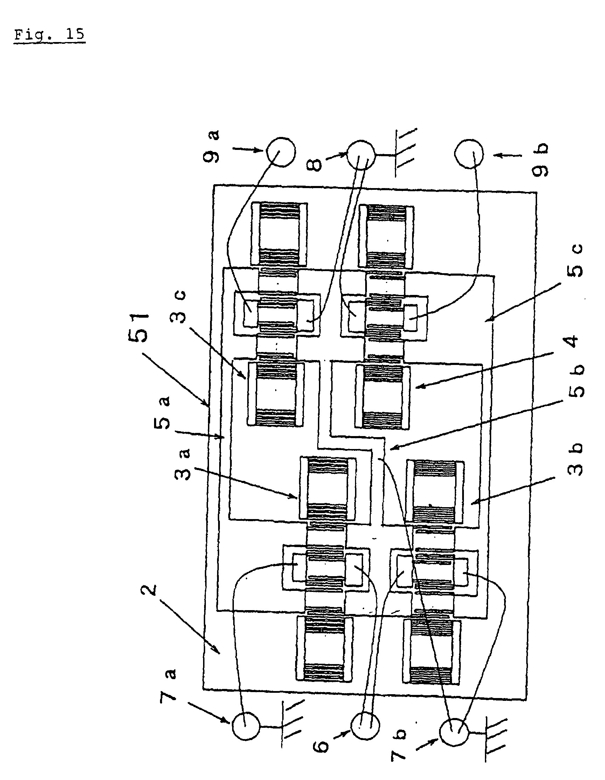

Fig. 15 is a view showing the construction of an elastic surface wave filter. device 51 according to a sixth embodiment of the present invention. Because the basic construction of the elastic surface wave filter device 51 is similar to that of the fourth embodiment, the same parts as those in the fourth embodiment are denoted by the same reference numerals and are not described here in detail.

This fifth embodiment differs from the fourth embodiment in that, as shown in Fig. 15, the connecting electrode 5b for cascading the elastic surface wave filter 3a to the elastic surface wave filter 3c and the elastic surface wave filter 3b to the elastic surface wave filter 4 is connected to the ground terminal 7b.

The above structure makes it possible to suppress the effect of directly incoming waves in the vicinity of the pass band. Note that the similar advantage can also be provided by grounding, instead of the connecting electrode 5b, other two 5a, 5c of the connecting electrodes 5a, 5b, 5c for cascading the elastic surface wave filter 3a to the elastic surface wave filter 3c and the elastic surface wave filter 3b to the elastic surface wave filter 4.

With the construction of Fig. 15 showing the sixth embodiment, since the effect of directly incoming waves in the vicinity of the pass band is suppressed, attenuation can be increased, particularly, on the higher-frequency side of the pass band.

As with the fourth embodiment explained above, the construction of this sixth embodiment can prevent the amplitude and phase from being disturbed upon the electrode fingers inherently kept at the ground potential changing to the electrode fingers on the signal side. Accordingly, although one 5b or two 5a, 5c of the electrodes 5a, 5b, 5c for connecting between the elastic surface wave filters 3a and 3c and between the elastic surface wave filters 3b and 4, amplitude and phase characteristics within the pass band are not disturbed on the balanced output side.

Fig. 16 shows a change in transmission characteristic resulted from this sixth embodiment when the electrode 5b is grounded. The plotted characteristic was measured through a balun by using a network analyzer (50 Ω system). Comparing with the case of the electrode 5b being not grounded (indicated by a broken line in Fig. 16), it is apparent that attenuation is improved from 25 dB to 30 dB on the higher-frequency side of the pass band according to the construction of this sixth embodiment.

It is to be noted that while the above first to sixth embodiments have been all described in connection with, by way of example, a construction of unbalanced input - balanced output, the manner of connecting the filters may be reversed from that explained above if a construction of balanced input - unbalanced output is required.

In addition, the similar advantages can be obtained without being affected by substrate materials.

According to the first aspect of the present invention, since elastic surface wave filters are cascaded in multiple stages and the filter device can have such a construction that IDTs connected between the stages have no ground terminals, the filter device can develop a buffer effect. Further, since two elastic surface wave filters are connected in parallel on the input side and two elastic surface wave filters are connected in series on the output side with one of the two filters providing reversed phase, output impedance is about four times as much as input impedance and a balanced output is obtained.

According to the second aspect, since the balanced operation with a neutral potential given by the ground potential is realized, it is possible to realize an elastic surface wave filter device which can suppress directly incoming waves more positively than with the floating operation and is superior in suppressing unnecessary waves.

According to the third to fifth aspects, by making the orientation of the input IDT or the output IDT reversed on the side where the IDT is connected to lie between the cascaded stages, or making the spacing between the input and output IDTs of the relevant filter different about 0.5 wavelength or a multiple of any integer and 0.5 wavelength from that of the other filters, the phase can be reversed.

Particularly, according to the fifth aspect, since the phase is reversed by making the spacing between the input and output IDTs of the relevant filter different about 0.5 wavelength or a multiple of any integer and 0.5 wavelength from that of the other filters, disturbances of the amplitude and phase caused upon the electrode fingers inherently kept at the ground potential changing to the electrode fingers on the signal side can be prevented.

According to the sixth aspect, since the common electrodes on the side connected to the balanced input/-output terminals have the same number of electrode fingers for both the first and second sets of cascaded elastic surface wave filters, directly incoming waves can be suppressed with increased attenuation.

According to the seventh aspect, since all the IDTs of the elastic surface wave filters on the side led out to external terminals comprise electrode fingers in even number, the effect of parasitic capacitance is equal between two terminals on the balanced output side even with the orientation of the IDT reversed. As a result, signals obtained from the balanced terminals can have characteristics of the same amplitude and opposite phase within the pass band and of the same amplitude and phase outside the pass band.

## Claims

1. An elastic surface acoustic wave filter apparatus (1; 11; 21; 31; 41; 51) comprising:
a first set of cascaded elastic surface acoustic wave filters (3b, 4; 34; 43b, 44)) including a first elastic surface acoustic wave filter (3b; 43b) having a predetermined value of an input/output phase characteristic within a pass band of said elastic surface acoustic wave filter apparatus (1; 11; 21; 31; 41; 51) and a second elastic surface acoustic wave filter (4; 34; 44) having an input/output phase characteristic that is different by about 180 degrees from said predetermined value of the input/output phase characteristic of the first elastic surface acoustic wave filter (3b; 43b) within the pass band of said elastic surface acoustic wave filter apparatus (1; 11; 21; 31; 41; 51), said first and second elastic surface acoustic wave filters (3b, 4; 34; 43b, 44) being electrically connected to each other in a cascade arrangement such that said first set of cascaded elastic surface acoustic wave filters (3b, 4; 34; 43b, 44) has a pair of first input/output terminals (6, 7b) and a pair of second input/output terminals (8, 9b, 18); and
a second set of cascaded elastic surface acoustic wave filters (3a, 3c; 23c; 43a, 43c) including a third elastic surface acoustic wave filter (3a; 43a) having said predetermined value of input/output phase characteristic within a pass band of said elastic surface acoustic wave filter apparatus (1; 11; 21; 31; 41; 51) and a fourth elastic surface acoustic wave filter (3c; 23c; 43c) having said predetermined value of input/output phase characteristic within the pass band of said elastic surface acoustic wave filter apparatus, said third and fourth elastic surface acoustic wave filters (3a, 3c; 23c; 43a, 43c) being electrically connected to each other in a cascade arrangement such that said second set of cascaded elastic surface acoustic wave filters (3a, 3c; 23c; 43a, 43c) has a pair of third input/output terminals (6, 7a) and a pair of fourth input/output terminals (8, 9a; 18); wherein
said pair of first input/output terminals of said first set of cascaded elastic surface acoustic wave filters (3b, 4; 34; 43b, 44) and said pair of third input/output terminals of said second set of cascaded elastic surface acoustic wave filters (3a, 3c; 23c; 43a, 43c) are electrically connected in parallel to define an unbalanced input/output terminal (6) and a grounded terminal (7a, 7b), and said pair of second input/output terminals of said first set of cascaded elastic surface acoustic wave filters (3b, 4) and said pair of fourth input/output terminals of said second set of cascaded elastic surface acoustic wave filters (3a, 3c; 23c, 43a, 43c) are electrically connected in series to define a pair of balanced input/output terminals (9a, 9b).

2. The elastic surface acoustic wave filter apparatus according to claim 1, wherein a series connection point (18) of said second input/output terminal and said fourth input/output terminal is grounded.

3. The elastic surface acoustic wave filter apparatus according of claim 1 or claim 2, wherein each of said first and third elastic surface acoustic wave filter (3b, 3a; 43b, 43a) comprises an input IDT and a pair of output IDTs between which said input IDT is interposed and each of said second and fourth elastic surface acoustic wave filters (4, 3c; 44, 43c) comprises an output IDT and a pair of input IDTs between which said output IDT, and said output IDT of the second elastic surface acoustic wave filter (4; 44) is configured in the opposite orientation to said input IDT of said first elastic surface acoustic wave filter (3b; 43b) and said input IDTs of the second elastic surface acoustic wave filter (4; 44) are configured in the same orientation as that of said output IDTs of said first elastic surface acoustic wave filter (3b; 43b).

4. The elastic surface acoustic wave filter apparatus according to claim 1 or claim 2, wherein each of said first and third elastic surface acoustic wave filters comprises an input IDT and a pair of output IDTs between which said input IDT and is interposed each of said second and fourth elastic surface acoustic wave filters comprises an output IDT and a pair of input IDTs between which said output IDT is interposed, and said output IDT of the second elastic surface acoustic wave filter is configured in the same orientation as that of said input IDT of said first elastic surface acoustic wave filter and said input IDTs of the second elastic surface acoustic wave filter are configured in the opposite orientation to said output IDTs of said first elastic surface acoustic wave filter.

5. The elastic surface acoustic wave filter apparatus according to claim 1 or claim 2, wherein each of said first and third elastic surface acoustic wave filters (3b, 3a) comprises an input IDT and a pair of output IDTs between which said input IDT is interposed and each of said second and fourth elastic surface acoustic wave filters (3c, 34), comprises an output IDT and a pair of input IDTs between which said output IDT is interposed, and said second elastic surface acoustic wave filter (34) has a spacing between an electrode finger of one of its input IDTs and an electrode finger of its output IDT that is different by a multiple of any integer plus about 0.5 wavelength from that of said first elastic surface acoustic wave filter (3b).

6. The elastic surface acoustic wave filter apparatus according to claim 3 or claim 4, wherein said pair of balanced input/output terminals (9a, 9b) are connected to respective electrodes of said output IDTs of said second and fourth elastic surface acoustic wave filters (4, 23c), respectively, which have the same number of electrode fingers.

7. The elastic surface acoustic wave filter apparatus according to claim 3 or claim 4, wherein said input IDTs of said first and third elastic surface acoustic wave filters (43b, 43a) and said output IDTs of said second and fourth elastic surface acoustic wave filters (44, 43c) have an even number of electrode fingers.

8. The elastic surface acoustic wave filter apparatus according or claim 1 or claim 2, wherein each of said second and fourth elastic surface acoustic wave filters (4, 3c; 44; 43c) comprises an input IDT and a pair of output IDTs between which said input IDT is interposed and each of said first and third elastic surface acoustic wave filters (3b, 3a; 43b, 43a) comprises an output IDT and a pair of input IDTs between which said output IDT is interposed; and said input IDT of the second elastic surface acoustic wave filter (4; 44) is configured in the opposite orientation to said output IDT of said first elastic surface acoustic wave filter (3b; 43b) and said output IDTs of the second elastic surface acoustic wave filter (4; 44) are configured in the same orientation as that of said input IDTs of said first elastic surface acoustic wave filter (3b; 43b).

9. The elastic surface acoustic wave filter apparatus according to claim 1 or claim 2, wherein each of said second and fourth elastic surface acoustic wave filters comprises an input IDT and a pair of output IDTs between which said input IDT is interposed and each of said first and third elastic surface acoustic wave filters comprises an output IDT and a pair of input IDTs between which said output IDT is interposed, and said input IDT of the second elastic surface acoustic wave filter is configured in the same orientation as that of said output IDT of said first elastic surface acoustic wave filter and said output IDTs of the second elastic surface acoustic wave filter are configured in the opposite orientation to said input IDTs of said first elastic surface acoustic wave filter.

10. The elastic surface acoustic wave filter apparatus according to claim 1 or claim 2, wherein each of said second and fourth elastic surface acoustic wave filters (3c, 34) comprises an input IDT and a pair of output IDTs between which said input IDT is interposed and each of said first and third elastic surface acoustic wave filters (3b, 3a) comprises an output IDT and a pair of input IDTs between which said output IDT is interposed, and said second elastic surface acoustic wave filter (34) has a spacing between an electrode finger of its input IDT and an electrode finger of one of its output IDTs that is different by a multiple of any integer plus about 0.5 wavelength from that of said first elastic surface acoustic wave filter (3b).

11. The elastic surface acoustic wave filter apparatus according to claim 8 or claim 9, wherein said pair of balanced input/output terminals (9a, 9b) are connected to respective electrodes of said input IDTs of said second and fourth elastic surface acoustic wave filters (4, 23c), respectively, which have the same number of electrode fingers.

12. The elastic surface acoustic wave filter apparatus according to claim 8 or claim 9, wherein said output IDTs of said first and third elastic surface acoustic wave filters (43b, 43a) and said input IDTs of said second and fourth elastic surface acoustic wave filters (44, 43c) have an even number of electrode fingers.

## Patentansprüche

1. Filtervorrichtung mit elastischen Oberflächenschallwellen (1; 11; 21; 31; 41; 51), umfassend:
eine erste Gruppe von kaskadenförmig angeordneten Filtern mit elastischen Oberflächenschallwellen (3b, 4; 34; 43b; 44), darin eingeschlossen ein erster Filter mit elastischen Oberflächenschallwellen (3b; 43b) mit einem vorbestimmten Wert einer Input/Output-Phasen-Charakteristik innerhalb eines Durchlassbereichs der Filtervorrichtung mit elastischen Oberflächenschallwellen (1; 11; 21; 31; 41; 51) und ein zweiter Filter mit elastischen Oberflächenschallwellen (4; 34; 44) mit einer Input/Output-Phasen-Charakteristik, die sich um etwa 180 Grad von dem vorbestimmten Wert der Input/Output-Phasen-Charakteristik des ersten Filters mit elastischen Oberflächenschallwellen (3b; 43b) innerhalb des Durchlassbereichs der Filtervorrichtung mit elastischen Oberflächenschallwellen (1; 11; 21; 31; 41; 51) unterscheidet, wobei der erste und zweite Filter mit elastischen Oberflächenschallwellen (3b, 4; 34; 43b, 44) elektrisch miteinander in kaskadenförmiger Anordnung verbunden sind, sodass die erste Gruppe von kaskadenförmig angeordneten Filtern mit elastischen Oberflächenschallwellen (3b, 4; 34; 43b 44) ein Paar von ersten Input/Output-Anschlussstellen (6, 7b) und ein Paar von zweiten Input/Output-Anschlussstellen (8, 9b, 18) aufweist; und
eine zweite Gruppe von kaskadenförmig angeordneten Filtern mit elastischen Oberflächenschallwellen (3a, 3c; 23c; 43a, 43c), darin eingeschlossen ein dritter Filter mit elastischen Oberflächenschallwellen (3a; 43a) mit einem vorbestimmten Wert einer Input/Output-Phasen-Charakteristik innerhalb eines Durchlassbereichs der Filtervorrichtung mit elastischen Oberflächenschallwellen (1; 11; 21; 31; 41; 51) und ein vierter Filter mit elastischen Oberflächenschallwellen (3c; 23c; 43c), wobei der vorbestimmte Wert der Input/Output-Phasen-Charakteristik innerhalb des Durchlassbereichs des Filters mit elastischen Oberflächenschallwellen liegt, wobei der dritte und vierte Filter mit elastischen Oberflächenschallwellen (3a, 3c; 23c; 43a, 43c) elektrisch miteinander in kaskadenförmiger Anordnung verbunden sind, sodass die zweiter Gruppe von kaskadenförmig angeordneten Filtern mit elastischen Oberflächenschallwellen (3a, 3c; 23c; 43a, 43c) ein Paar von dritten Input/Output-Anschlussstellen (6, 7a) und ein Paar von vierten Input/Output-Anschlussstellen (8, 9a, 18) aufweist; wobei
das Paar von ersten Input/Output-Anschlussstellen der ersten Gruppe von kaskadenförmig angeordneten Filtern mit elastischen Oberflächenschallwellen (3b, 4; 34; 43b, 44) und das Paar von dritten Input/Output-Anschlussstellen der zweiten Gruppe von kaskadenförmig angeordneten Filtern mit elastischen Oberflächenschallwellen (3a, 3c; 23c; 43a; 43c) elektrisch parallel miteinander verbunden sind, um eine unausgeglichene Input/Output-Anschlussstelle (6) und eine geerdete Anschlussstelle (7a, 7b) zu definieren, und wobei das Paar von zweiten Input/Output-Anschlussstellen der ersten Gruppe von kaskadenförmig angeordneten Filtern mit elastischen Oberflächenschallwellen (3b, 4) und das Paar von vierten Input/Output-Anschlussstellen der zweiten Gruppe von kaskadenförmig angeordneten Filtern mit elastischen Oberflächenschallwellen (3a, 3c; 23c, 43a, 43c) elektrisch miteinander in Serie verbunden sind, um ein Paar von ausgeglichenen Input/Output-Anschlussstellen (9a, 9b) zu definieren.

2. Filtervorrichtung mit elastischen Oberflächenschallwellen nach Anspruch 1, wobei ein Serienanordnungspunkt (18) der zweiten Input/Output-Anschlussstelle und der vierten Input/Output-Anschlussstelle geerdet sind.

3. Filtervorrichtung mit elastischen Oberflächenschallwellen nach Anspruch 1 oder Anspruch 2, wobei jeder der ersten und dritten Filter mit elastischen Oberflächenschallwellen (3b, 3a; 43b, 43a) eine Input-IDT und ein Paar von Output-BDTs umfasst, zwischen welchen die Input-IDT eingefügt ist und wobei jeder der zweiten und vierten Filter mit elastischen Oberflächenschallwellen (4, 3c; 44, 43c) eine Output-IDT und Paar von Input-IDTs umfasst, zwischen welchen die Output-IDT und die Output-IDT des zweiten Filters mit elastischen Oberflächenschallwellen (4; 44) in entgegengesetzter Ausrichtung zu der Input-IDT des ersten Filters mit elastischen Oberflächenschallwellen (3b; 43b) konfiguriert ist und die Input-IDTs des zweiten Filters mit elastischen Oberflächenschallwellen (4; 44) in derselben Ausrichtung wie diejenige der Output-IDTs des ersten Filters mit elastischen Oberflächenschallwellen (3b; 43b) konfiguriert sind.

4. Filtervorrichtung mit elastischen Oberflächenschallwellen nach Anspruch 1 oder Anspruch 2, wobei jeder der ersten und dritten Filter mit elastischen Oberflächenschallwellen eine Input-IDT und ein Paar von Output-IDTs umfasst, zwischen welchen die Input-IDT eingefügt ist und wobei jeder der zweiten und vierten Filter mit elastischen Oberflächenschallwellen eine Output-IDT und Paar von Input-IDTs umfasst, zwischen welchen die Output-IDT eingefügt ist und die Output-IDT des zweiten Filters mit elastischen Oberflächenschallwellen in der gleichen Ausrichtung konfiguriert ist wie diejenige der Input-IDT des ersten Filters mit elastischen Oberflächenschallwellen und die Input-IDTs des zweiten Filters mit elastischen Oberflächenschallwellen in entgegengesetzter Ausrichtung zu den Output-IDTs des ersten Filters mit elastischen Oberflächenschallwellen konfiguriert sind.

5. Filtervorrichtung mit elastischen Oberflächenschallwellen nach Anspruch 1 oder Anspruch 2, wobei jeder der ersten und dritten Filter mit elastischen Oberflächenschallwellen (3b, 3a) eine Input-IDT und ein Paar von Output-IDTs umfasst, zwischen welchen der Input-IDT eingefügt ist und wobei jeder der zweiten und vierten Filter mit elastischen Oberflächenschallwellen (3c, 34) eine Output-IDT und Paar von Input-IDTs umfasst, zwischen welchen die Output-IDT eingefügt ist, und der Filter mit elastischen Oberflächenschallwellen (34) einen Zwischenraum zwischen einem Elektrodenfinger von einer seiner Input-IDTs und einem Elektrodenfinger seiner Output-IDT aufweist, der sich um das Vielfache einer ganzen Zahl plus etwa 0,5 Wellenlänge von demjenigen des ersten Filters mit elastischen Oberflächenschallwellen (3b) unterscheidet.

6. Filtervorrichtung mit elastischen Oberflächenschallwellen nach Anspruch 3 oder Anspruch 4, wobei das Paar von ausgeglichenen Input/Output-Anschlussstellen (9a, 9b) mit den betreffenden Elektroden der Output-IDTs des zweiten bzw. vierten Filters mit elastischen Oberflächenschallwellen (4, 23c) verbunden ist, welche die gleiche Anzahl an Elektrodenfingern aufweisen.

7. Filtervorrichtung mit elastischen Oberflächenschallwellen nach Anspruch 3 oder Anspruch 4, wobei das Paar die Inupt-IDTs des ersten und dritten Filters mit elastischen Oberflächenschallwellen (43b, 43a) und die Output-IDTs des zweiten und vierten Filters mit elastischen Oberflächenschallwellen (44, 43c) die gleiche Anzahl an Elektrodenfingern aufweisen.

8. Filtervorrichtung mit elastischen Oberflächenschallwellen nach Anspruch 1 oder Anspruch 2, wobei jeder der zweiten und vierten Filter mit elastischen Oberflächenschallwellen (4, 3c; 44; 43c) eine Input-IDT und ein Paar von Output-IDTs umfasst, zwischen welchen die Input-IDT eingefügt ist, und wobei jeder der ersten und dritten Filter mit elastischen Oberflächenschallwellen (3b, 3a; 43b, 43a) eine Output-IDT und Paar von Input-IDTs umfasst, zwischen welchen die Output-IDT eingefügt ist, und die Input-IDT des zweiten Filters mit elastischen Oberflächenschallwellen (4; 44) in entgegengesetzter Ausrichtung zu der Output-IDT des ersten Filters mit elastischen Oberflächenschallwellen (3b; 43b) konfiguriert ist, und die Output-IDTs des zweiten Filters mit elastischen Oberflächenschallwellen (4; 44) in der gleichen Ausrichtung konfiguriert sind wie diejenige der Input-IDTs des ersten Filters mit elastischen Oberflächenschallwellen (3b; 43b).

9. Filtervorrichtung mit elastischen Oberflächenschallwellen nach Anspruch 1 oder Anspruch 2, wobei jeder der zweiten und vierten Filter mit elastischen Oberflächenschallwellen eine Input-IDT und ein Paar von Output-IDTs umfasst, zwischen welchen die Input-IDT eingefügt ist, und wobei jeder der ersten und dritten Filter mit elastischen Oberflächenschallwellen eine Output-IDT und Paar von Input-IDTs umfasst, zwischen welchen die Output-IDT eingefügt ist, und die Input-IDT des zweiten Filters mit elastischen Oberflächenschallwellen in der gleichen Ausrichtung wie diejenige des Output-IDT des ersten Filters mit elastischen Oberflächenschallwellen konfiguriert ist, und die Output-IDTs des zweiten Filters mit elastischen Oberflächenschallwellen in entgegengesetzter Ausrichtung zu derjenigen der Input-IDTs des ersten Filters mit elastischen Oberflächenschallwellen konfiguriert sind.

10. Filtervorrichtung mit elastischen Oberflächenschallwellen nach Anspruch 1 oder Anspruch 2, wobei jeder der zweiten und vierten Filter mit elastischen Oberflächenschallwellen (3c, 34) eine Input-IDT und ein Paar von Output-IDTs umfasst, zwischen welchen die Input-IDT eingefügt ist, und wobei jeder der ersten und dritten Filter mit elastischen Oberflächenschallwellen (3b, 3a) eine Output-IDT und Paar von Input-IDTs umfasst, zwischen welchen die Output-IDT eingefügt ist, und der zweite Filter mit elastischen Oberflächenschallwellen (34) einen Zwischenraum zwischen einem Elektrodenfinger seiner Input-IDT und einem Elektrodenfinger von einer seiner Output-IDTs aufweist, der sich um das Vielfache einer ganzen Zahl plus etwa 0,5 Wellenlänge von demjenigen des ersten Filters mit elastischen Oberflächenschallwellen (3b) unterscheidet.

11. Filtervorrichtung mit elastischen Oberflächenschallwellen nach Anspruch 8 oder Anspruch 9, wobei das Paar von ausgeglichenen Input/Output-Anschlussstellen (9a, 9b) mit den betreffenden Elektroden der Input-IDTs des zweiten bzw. vierten Filters mit elastischen Oberflächenschallwellen (4, 23c) verbunden ist, welche die gleiche Anzahl an Elektrodenfingern aufweisen.

12. Filtervorrichtung mit elastischen Oberflächenschallwellen nach Anspruch 8 oder Anspruch 9, wobei die Output-IDTs des ersten und dritten Filters mit elastischen Oberflächenschallwellen (43b, 43a) und die Input-IDTs des zweiten und vierten Filters mit elastischen Oberflächenschallwellen (44, 43c) die gleiche Anzahl an Elektrodenfingern aufweisen.

## Revendications

1. Appareil de filtres à ondes acoustiques de surface élastiques (1 ; 11 ; 21 ; 31 ; 41 ; 51) comprenant :
un premier jeu de filtres à ondes acoustiques de surface élastiques montés en cascade (3b, 4 ; 34 ; 43b, 44) qui inclut un premier filtre à ondes acoustiques de surface élastiques (3b; 43b) qui présente une valeur prédéterminée d'une caractéristique de phase d'entrée/sortie à l'intérieur d'une bande passante dudit appareil de filtres à ondes acoustiques de surface élastiques (1; 11; 21; 31 ; 41; 51) et un second filtre à ondes acoustiques de surface élastiques (4; 34; 44) qui présente une caractéristique de phase d'entrée/sortie qui est différente d'environ 180 degrés de ladite valeur prédéterminée de la caractéristique de phase d'entrée/sortie du premier filtre à ondes acoustiques de surface élastique (3b ; 43b) à l'intérieur de la bande passante dudit appareil de filtres à ondes acoustiques de surface élastiques (1 ;11 ; 21 ; 31 ; 41 ; 51), lesdits premier et second filtres à ondes acoustiques de surface élastiques (3b, 4 ; 34 ; 43b, 44) étant connectés électriquement l'un à l'autre selon un agencement en cascade de telle sorte que ledit premier jeu de filtres à ondes acoustiques de surface élastiques montés en cascade (3b, 4; 34; 43b, 44) comporte une paire de premières bornes d'entrée/sortie (6, 7b) et une paire de secondes bornes d'entrée/sortie (8, 9b, 18); et
un second jeu de filtres à ondes acoustiques de surface élastiques montés en cascade (3a, 3c; 23c; 43a, 43c) qui inclut un troisième filtre à ondes acoustiques de surface élastiques (3a; 43a) qui présente ladite valeur prédéterminée de caractéristique de phase d'entrée/sortie à l'intérieur d'une bande passante dudit appareil de filtres à ondes acoustiques de surface élastiques (1; 11 ; 21; 31; 41; 51) et un quatrième filtre à ondes acoustiques de surface élastiques (3c ; 23c; 43c) qui présente ladite valeur prédéterminée de caractéristique de phase d'entrée/sortie à l'intérieur de la bande passante dudit appareil de filtres à ondes acoustiques de surface élastiques, lesdits troisième et quatrième filtres à ondes acoustiques de surface élastiques (3a, 3c; 23c ; 43a, 43c) étant connectés électriquement l'un à l'autre selon un agencement en cascade de telle sorte que ledit second jeu de filtres à ondes acoustiques de surface élastiques (3a, 3c; 23c; 43a, 43c) comporte une paire de troisièmes bornes d'entrée/sortie (6, 7a) et une paire de quatrièmes bornes d'entrée/sortie (8, 9a ; 18),
dans lequel :
ladite paire de premières bornes d'entrée/sortie dudit premier jeu de filtres à ondes acoustiques de surface élastiques montés en cascade (3b, 4; 34 ; 43b, 44) et ladite paire de troisièmes bornes d'entrée/sortie dudit second jeu de filtres à ondes acoustiques de surface élastiques montés en cascade (3a, 3c; 23c; 43a, 43c) sont connectées électriquement en parallèle afin de définir une borne d'entrée/sortie déséquilibrée (6) et une borne de mise à la masse (7a, 7b), et ladite paire de secondes bornes d'entrée/sortie dudit premier jeu de filtres à ondes acoustiques de surface élastiques montés en cascade (3b, 4) et ladite paire de quatrièmes bornes d'entrée/sortie dudit second jeu de filtres à ondes acoustiques de surface élastiques montés en cascade (3a, 3c; 23c; 43a, 43c) sont connectées électriquement en série afin de définir une paire de bornes d'entrée/sortie équilibrées (9a, 9b).

2. Appareil de filtres à ondes acoustiques de surface élastiques selon la revendication 1, dans lequel un point de connexion série (18) de ladite seconde borne d'entrée/sortie et de ladite quatrième borne d'entrée/sortie est relié à la masse.

3. Appareil de filtres à ondes acoustiques de surface élastiques selon la revendication 1 ou la revendication 2, dans lequel chacun desdits premier et troisième filtres à ondes acoustiques de surface élastiques (3b, 3a ; 43b, 43a) comprend un IDT d'entrée et une paire de IDT de sortie entre lesquels ledit IDT d'entrée est interposé et chacun desdits second et quatrième filtres à ondes acoustiques de surface élastiques (4, 3c ; 44, 43c) comprend un IDT de sortie et une paire de IDT d'entrée entre lesquels ledit IDT de sortie est interposé, et ledit IDT de sortie du second filtre à ondes acoustiques de surface élastiques (4; 44) est configuré selon l'orientation opposée par rapport à celle dudit IDT d'entrée dudit premier filtre à ondes acoustiques de surface élastiques (3b; 43b) et lesdits IDT d'entrée du second filtre à ondes acoustiques de surface élastiques (4 ; 44) sont configurés selon la même orientation que celle desdits IDT de sortie dudit premier filtre à ondes acoustiques de surface élastiques (3b ; 43b).

4. Appareil de filtres à ondes acoustiques de surface élastiques selon la revendication 1 ou 2, dans lequel chacun desdits premier et troisième filtres à ondes acoustiques de surface élastiques comprend un IDT d'entrée et une paire de IDT de sortie entre lesquels ledit IDT d'entrée est interposé et chacun desdits second et quatrième filtres à ondes acoustiques de surface élastiques comprend un IDT de sortie et une paire de IDT d'entrée entre lesquels ledit IDT de sortie est interposé, et ledit IDT de sortie du second filtre à ondes acoustiques de surface élastique est configuré selon la même orientation que celle dudit IDT d'entrée dudit premier filtre à ondes acoustiques de surface élastiques et lesdits IDT d'entrée du second filtre à ondes acoustiques de surface élastiques sont configurés selon l'orientation opposée par rapport à celle desdits IDT de sortie dudit premier filtre à ondes acoustiques de surface élastiques.

5. Appareil de filtres à ondes acoustiques de surface élastiques selon la revendication 1 ou la revendication 2, dans lequel chacun desdits premier et troisième filtres à ondes acoustiques de surface élastiques (3b, 3a) comprend un IDT d'entrée et une paire de IDT de sortie entre lesquels ledit IDT d'entrée est interposé et chacun desdits second et quatrième filtres à ondes acoustiques de surface élastiques (3c, 34) comprend un IDT de sortie et une paire de IDT d'entrée entre lesquels ledit IDT de sortie est interposé, et ledit second filtre à ondes acoustiques de surface élastiques (34) présente un espacement entre un doigt d'électrode de l'un de ses IDT d'entrée et un doigt d'électrode de son IDT de sortie qui est différent d'un multiple de n'importe quel entier plus environ 0,5 fois la longueur d'onde de celui dudit premier filtre à ondes acoustiques de surface élastiques (3b).

6. Appareil de filtres à ondes acoustiques de surface élastiques selon la revendication 3 ou la revendication 4, dans laquelle les bornes de ladite paire de bornes d'entrée/sortie équilibrées (9a, 9b) sont respectivement connectées à des électrodes respectives desdits IDT de sortie desdits second et quatrième filtres à ondes acoustiques de surface (4, 23c), qui présentent le même nombre de doigts d'électrode.

7. Appareil de filtres à ondes acoustiques de surface élastiques selon la revendication 3 ou la revendication 4, dans lequel lesdits IDT d'entrée desdits premier et troisième filtres à ondes acoustiques de surface élastiques (43b, 43a) et lesdits IDT de sortie desdits second et quatrième filtres à ondes acoustiques de surface élastiques (44, 43c) comportent un nombre pair de doigts d'électrode.

8. Appareil de filtres à ondes acoustiques de surface élastiques selon la revendication 1 ou 2, dans lequel chacun desdits second et quatrième filtres à ondes acoustiques de surface élastiques (4, 3c ; 44; 43c) comprend un IDT d'entrée et une paire de IDT de sortie entre lesquels ledit IDT d'entrée est interposé et chacun desdits premier et troisième filtres à ondes acoustiques de surface élastiques (3b, 3a ; 43b, 43a) comprend un IDT de sortie et une paire de IDT d'entrée entre lesquels ledit IDT de sortie est interposé, et ledit IDT d'entrée du second filtre à ondes acoustiques de surface élastiques (4 ; 44) est configuré selon l'orientation opposée par rapport à celle dudit IDT de sortie dudit premier filtre à ondes acoustiques de surface élastiques (3b ; 43b) et lesdits IDT du second filtre à ondes acoustiques de surface élastiques (4 ; 44) sont configurés selon la même orientation que celle desdits IDT d'entrée dudit premier filtre à ondes acoustiques de surface élastiques (3b ; 43b).

9. Appareil de filtres à ondes acoustiques de surface élastiques selon la revendication 1 ou la revendication 2, dans lequel chacun desdits second et quatrième filtres à ondes acoustiques de surface élastiques comprend un IDT d'entrée et une paire de IDT de sortie entre lesquels ledit IDT d'entrée est interposé et chacun desdits premier et troisième filtres à ondes acoustiques de surface élastiques comprend un IDT de sortie et une paire de IDT d'entrée entre lesquels ledit IDT de sortie est interposé, et ledit IDT d'entrée du second filtre à ondes acoustiques de surface élastiques est configuré selon la même orientation que celle dudit IDT de sortie dudit premier filtre à ondes acoustiques de surface élastiques et lesdits IDT de sortie du second filtre à ondes acoustiques de surface élastiques sont configurés selon l'orientation opposée par rapport à celle desdits IDT d'entrée dudit premier filtre à ondes acoustiques de surface élastiques.

10. Appareil de filtres à ondes acoustiques de surface élastiques selon la revendication 1 ou la revendication 2, dans lequel chacun desdits second et quatrième filtres à ondes acoustiques de surface élastiques (3c, 34) comprend un IDT d'entrée et une paire de IDT de sortie entre lesquels ledit IDT d'entrée est interposé et chacun desdits premier et troisième filtres à ondes acoustiques de surface élastiques (3b, 3a) comprend un IDT de sortie et une paire de IDT d'entrée entre lesquels ledit IDT de sortie est interposé et ledit second filtre à ondes acoustiques de surface élastiques (34) présente un espacement entre un doigt d'électrode de son IDT d'entrée et un doigt d'électrode de l'un de ses IDT de sortie qui est différent d'un multiple de m'importe quel entier plus environ 0,5 fois la longueur d'onde de celui dudit premier filtre à ondes acoustiques de surface élastiques (3b).

11. Appareil de filtres à ondes acoustiques de surface élastiques selon la revendication 8 ou la revendication 9, dans lequel les bornes de ladite paire de bornes d'entrée/sortie équilibrées (9a, 9b) sont respectivement connectées à des électrodes respectives desdits IDT d'entrée desdits second et quatrième filtres à ondes acoustiques de surface élastiques (4, 23c), qui présentent le même nombre de doigts d'électrode.

12. Appareil de filtres à ondes acoustiques de surface élastiques selon la revendication 8 ou la revendication 9, dans lequel lesdits IDT de sortie desdits premier et troisième filtres à ondes acoustiques de surface élastiques (43b, 43a) et lesdits IDT d'entrée desdits second et quatrième filtres à ondes acoustiques de surface élastiques (44, 43c) présentent un nombre pair de doigts d'électrode.
